# EUROPEAN PATENT APPLICATION

(11) **EP 4 411 832 A2**
(43) Date of publication of application: **07.08.2024**
(21) Application number: 24182029.9
(22) Date of filing: 13.06.2024
(51) Int. Cl.: H01L 31/0224, H01L 31/0745, H01L 31/068, H01L 31/0352, H01L 31/18

(54) **SOLAR CELL AND PREPARATION METHOD THEREOF, PHOTOVOLTAIC MODULE, AND PHOTOVOLTAIC SYSTEM**

(30) Priority: 15.12.2023 CN 202311724283
(71) Applicant: Trina Solar Co., Ltd., Changzhou, Jiangsu Province 213031 (CN)
(72) Inventor: CHEN, Daming, CHANGZHOU, 213031 (CN); LIU, Wei, CHANGZHOU, 213031 (CN); CHEN, Yifeng, CHANGZHOU, 213031 (CN); LV, Dongyun, CHANGZHOU, 213031 (CN)
(74) Representative: Arnold & Siedsma

(57) **Abstract**

A solar cell includes a semiconducting substrate, a first emitter, and a second emitter. The semiconducting substrate includes first and second surfaces. The semiconducting substrate includes first and second regions. The first direction is perpendicular to the thickness direction of the semiconducting substrate. The first emitter is in a first conductivity type. The first emitter is disposed on the first surface and including a groove. The groove divides the first emitter into a first sub-emitter and a second sub-emitter. The first sub-emitter is located on the first region. The second sub-emitter is located on the second region. The second emitter is in a second conductivity type, and the second emitter is disposed on the first surface and located on the second region. The minimum distance between the second emitter and the second surface is less than the minimum distance between the first emitter and the second surface.

## Description

This application claims priority to Chinese patent application No. 202311724283.X, filed on December 15, 2023, and titled "SOLAR CELL AND PREPARATION METHOD THEREOF, PHOTOVOLTAIC MODULE, AND PHOTOVOLTAIC SYSTEM".

### TECHNICAL FIELD

The present application relates to the field of solar cell technology, specifically to solar cells and preparation methods thereof, photovoltaic modules, and photovoltaic systems.

### BACKGROUND

Solar cells are devices that directly convert light energy into electrical energy through the photoelectric effect. Solar cells are commonly prepared on semiconductor chips or substrates by using semiconductor processing technology to form a p-n junction adjacent to a surface of the substrate.

In an interdigitated back contact (IBC) solar cell, p-n junctions are located on the back side of the substrate, with p-doped and n-doped areas alternately arranged along the surface of the substrate. Solar radiation that irradiates the front side of the substrate enters the substrate and induces generation of electron-hole pairs within the substrate. These electron-hole pairs migrate to the p-doped and n-doped areas on the back side of the substrate, thereby generating a voltage difference between the doped areas. The doped areas are electrically connected to an external circuit through metal electrodes, thereby conducting electric currents from the solar cell to the external circuit.

### SUMMARY

In view of this, there is a need to provide a solar cell, a method for preparing the same, a photovoltaic module, and a photovoltaic system.

A first aspect of the present application provides a solar cell, including a semiconducting substrate, a first emitter, and a second emitter.

The semiconducting substrate includes a first surface and a second surface opposite to each other, the semiconducting substrate includes a first region and a second region spaced apart from each other in a first direction, and the first direction is perpendicular to a thickness direction of the semiconducting substrate.

The first emitter is in a first conductivity type, the first emitter is disposed on the first surface and including a groove, the groove divides the first emitter into a first sub-emitter and a second sub-emitter, the first sub-emitter is located on the first region, and the second sub-emitter is located on the second region.

The second emitter is in a second conductivity type, and the second emitter is disposed on the first surface and located on the second region. The minimum distance between the second emitter and the second surface is less than the minimum distance between the first emitter and the second surface.

In some embodiments, the solar cell further includes a first tunneling layer and a second tunneling layer. The first tunneling layer is disposed between the first emitter and the semiconducting substrate. The second tunneling layer is disposed between the second emitter and the semiconducting substrate.

In some embodiments, the groove penetrates through the first tunneling layer, dividing the first tunneling layer into a first part located on the first region and a second part located on the second region.

In some embodiments, the second region includes a first sub-region and a second sub-region arranged adjacent to each other along the first direction, and the second sub-region is located at a side of the first sub-region adjacent to the first region; the second part covers the first surface of the semiconducting substrate in second sub-region; the second tunneling layer at least covers the first surface of the semiconducting substrate in the first sub-region and a sidewall of the second sub-emitter that is away from the groove.

In some embodiments, the minimum distance between the second tunneling layer located on the first sub-region and the second surface is less than the minimum distance between the first part and the second surface.

In some embodiments, the second tunneling layer further covers a sidewall of the second part away from the groove and a surface of the second sub-emitter away from the semiconducting substrate.

In some embodiments, the second emitter covers a sidewall of the second part away from the groove and a surface of the second sub-emitter away from the semiconducting substrate.

In some embodiments, the second part and the second tunneling layer satisfies 0<X1/X2 ≤1/10, where X1 is a size of the second part along the first direction, and X2 is a size of the second tunneling layer on the first sub-region along the first direction.

In some embodiments, the groove extends to reach the semiconducting substrate.

In some embodiments, a distance between the second tunneling layer located on the first sub-region and the second surface is less than or equal to a distance between a bottom surface of the groove, formed by the first surface in the groove, and the second surface.

In some embodiments, the solar cell further includes a first dielectric layer disposed on a side of the first emitter and the second emitter away from the semiconducting substrate, wherein the first dielectric layer further covers the groove.

In some embodiments, the solar cell further includes a first passivation layer, wherein the first passivation layer at least covers the groove.

In some embodiments, the first passivation layer further covers a surface of the first sub-emitter and a surface of the second emitter away from the semiconducting substrate.

In some embodiments, the semiconducting substrate includes a first diffusion region and a second diffusion region, both extending from the first surface towards the second surface, an orthogonal projection of the first emitter on the semiconducting substrate covers at least a part of the first diffusion region, and an orthogonal projection of the second emitter on the semiconducting substrate covers at least a part of the second diffusion region.

In some embodiments, the first diffusion region includes a first sub-diffusion region and a second sub-diffusion region spaced from each other in the first direction, an orthogonal projection of the first sub-emitter on the semiconducting substrate coincides with the first sub-diffusion region, and an orthogonal projection of the second sub-emitter on the semiconducting substrate coincides with the second sub-diffusion region.

In some embodiments, a size of the first sub-emitter along the first direction is greater than or equal to a size of the second emitter along the first direction; and/or an area of an orthogonal projection of the first sub-emitter on the semiconducting substrate is greater than or equal to an area of an orthogonal projection of the second emitter on the semiconducting substrate.

In some embodiments, a bottom surface of the groove has a micro-textured structure.

A second aspect of the present application provides a method for preparing a solar cell, including:
providing a semiconducting substrate, the semiconducting substrate including a first surface and a second surface opposite to each other, the semiconducting substrate including a first region and a second region spaced from each other in a first direction, the first direction being perpendicular to a thickness direction of the semiconducting substrate;
forming a first emitter in a first conductivity type on the first surface; and
forming a second emitter in a second conductivity type on the first surface in the second region, a minimum distance between the second emitter and the second surface being less than a minimum distance between the first emitter and the second surface; and
forming a groove in the first emitter, dividing the first emitter into a first sub-emitter located on the first region and a second sub-emitter located on the second region.

In some embodiments, the second region includes a first sub-region and a second sub-region arranged adjacent to each other along the first direction; forming the first emitter in the first conductivity type on the first surface includes:
forming a first tunneling material layer, a first emitter material layer, and a first silicon oxide dielectric layer that are stacked on the first surface; subjecting the semiconducting substrate with the stacked layers to a first heat treatment; and
removing the first silicon oxide dielectric material layer, the first emitter material layer, and the first tunneling material layer on the first sub-region.

In some embodiments, forming the second emitter in the second conductivity type on the first surface in the second region includes:
forming a second tunneling material layer, a second emitter material layer, and a second silicon oxide dielectric layer that are stacked on the first surface; subjecting the semiconducting substrate with the stacked layers to a second heat treatment;
removing the second silicon oxide dielectric layer, the second emitter material layer, and the second tunneling material layer on the first region and a spacing region, wherein the spacing region is the region of the semiconducting substrate between the first region and the second region.

A third aspect of the present application provides a photovoltaic module, including the solar cell in the first aspect.

A fourth aspect of the present application provides a photovoltaic system, including the photovoltaic module in the third aspect.

In the solar cell, the preparation method thereof, the photovoltaic module, and the photovoltaic system provided in the embodiments of the present application, the groove divides the first emitter into the first sub-emitter and the second sub-emitter. The first sub-emitter is located on the first region, and the second sub-emitter and the second emitter are located on the second region. In other words, the emitter on the first region (i.e., the first sub-emitter) is spaced from the emitter on the second region (i.e., the second sub-emitter and the second emitter) by the groove. Thus, on the one hand, the first region is spaced from the second region, which can effectively reduce carrier recombination in the solar cell, thereby improving the efficiency of the solar cell. On the other hand, in related art, since the minimum distance between the second emitter and the second surface is less than the minimum distance between the first emitter and the second surface, a groove may be formed between the first emitter and the second emitter to completely space the first emitter from the second emitter. In order to achieve a good spacing effect, the depth of the groove has to be greater than the depth of the second emitter. In contrast, in the embodiments of the present application, since the groove is located in the first emitter, as long as the depth of the groove is greater than that of the first emitter, the emitter on the first region (i.e., the first sub-emitter) can be spaced from the emitter on the second region (i.e., the second sub-emitter and the second emitter). As a result, the depth of the groove can be effectively reduced, thereby enhancing the structural strength of the solar cell and reducing the risk of breaking the solar cell.

### BRIEF DESCRIPTION OF THE DRAWINGS

In order to more clearly describe the embodiments or examples of the present application, the accompanying drawings to be used in the description of the embodiments or examples will be described briefly. Obviously, the drawings described below are only for some embodiments of the present application. For ordinary skilled persons in the art, other drawings can also be obtained based on the following drawings without creative works.
FIG. 1 is a schematic structural sectional partial view of a solar cell according to an embodiment of the present application.
FIG. 2 is a schematic structural sectional partial view of a solar cell according to another embodiment of the present application.
FIG. 3 is a schematic structural sectional partial view of a solar cell according to yet another embodiment of the present application.
FIG. 4A is a schematic structural sectional partial view of a solar cell according to yet another embodiment of the present application.
FIG. 4B is a schematic view showing the depths of a first emitter and a second emitter of the solar cell of FIG. 4A.
FIG. 5 is a flow chart of a method for preparing a solar cell according to an embodiment of the present application.
FIG. 6 to FIG. 17 are schematic structural sectional partial views of steps of the method of FIG. 5.
FIG. 18 is a schematic structural sectional partial view of another solar cell obtained by the method of FIG. 5.

### Reference Signs:

1, solar cell; 11, semiconducting substrate; 11a, first region; 11b, second region; 11b1, first sub-region; 11b2, second sub-region; 11c, spacing region; 111, first diffusion region; 1111, first sub-diffusion region; 1112, second sub-diffusion region; 112, second diffusion region; 121, first emitter; 1211, first sub-emitter; 1212, second sub-emitter; 122, second emitter; 13, groove; 141, first tunneling layer; 1411, first part; 1412, second part; 142, second tunneling layer; 15, first dielectric layer; 16, first passivation layer; 17, passivation layer group; 171, anti-reflection layer; 172, second passivation layer; 181, first electrode; 182, second electrode; 19, first silicon oxide dielectric layer; 2, first tunneling material layer; 3, first emitter material layer; 4, second tunneling material layer; 5, second emitter material layer; 6, second silicon oxide dielectric layer.

### DETAILED DESCRIPTION

The present application will now be described in detail with reference to the accompanying drawings in order to make the objects, features, and advantages of the present application more clear. In the following description, many specific details are explained to make the present application fully understandable. However, the present application can be implemented in many other ways different from those described herein, and those skilled in the art can make similar improvements without departing from the connotation of the present application. Therefore, the present application is not limited by the specific embodiments disclosed below.

Unless defined otherwise, all technical and scientific terms used herein have the same meaning as commonly understood by those skilled in the art of the present application. The terms used in the specification of the present application are for the purpose of describing exemplary examples only and are not intended to limit the present application.

It should be understood that when an element or a layer is referred to as being "on", "adjacent to", "connected to", or "coupled to" another element or layer, it can be directly on, adjacent to, connected to, or coupled to another element or layer, or an intermediate element or layer can be present. In contrast, when an element is referred to as being "directly on", "directly adjacent to", "directly connected to", or "directly coupled to" another element or layer, there is no intervening element or layer. It can be understood that although the terms "first", "second", "third" etc. may be used to describe various elements, components, regions, layers, sections, and/or doping types, these elements, components, regions, layers, sections, and/or doping types should not be limited by these terms. These terms are only used to distinguish one element, component, region, layer, section, and/or doping type from another element, component, region, layer, section, and/or doping type. Thus, a first element, component, region, layer, section, and/or doping type described below can be termed as a second element, component, region, layer, section, and/or doping type without departing from the teachings of the present application.

For the convenience of description, the spatial relation terms such as "below", "under", "beneath", "above", "on", "over", etc., may be used herein to describe the relationships of an element or a feature with other elements or features shown in the drawings. It should be understood that the terms of spatial relations are intended to include other different orientations in use or operation in addition to the orientation of the elements or features shown in the drawings. For example, if the drawings are placed upside down, the element or feature which was "above" or "over" other elements or features will be "below" or "under" other elements or features. Thus, the exemplary terms "below" and "beneath" may cover the meanings of "above" or "below". The element or feature can also be positioned in other different ways (e.g., rotating 90 degrees or at other orientations), and the spatial relation terms used herein can be correspondingly interpreted.

As used herein, the singular forms with "a", "an", "the", or "said" are intended to include the plural forms as well, unless the context clearly indicates otherwise. It should also be understood that the terms "consists of" and/or "comprising", when used in the present application, identify the presence of the stated features, integers, steps, operations, elements and/or parts, but do not exclude presence or addition of one or more other features, integers, steps, operations, elements, parts and/or groups. As used herein, the term "and/or" means that any one of the listed items can be employed by itself or any combination of two or more of the listed items can be employed.

The embodiments of the present application are described herein with reference to cross-sectional views of idealized embodiments (and intermediate structures) of the present application. It can be expected that some variations of the shown shapes may exist due to, for example, manufacturing techniques and/or engineering tolerances. Thus, embodiments of the present application should not be limited to the particular shapes of the regions shown herein but include deviations in shapes due to, for example, manufacturing. The regions shown in the drawings are schematic in nature, and their shapes are not intended to be the actual shapes of the regions of the device or limit the scope of the present application.

In the present application, when mentioning that an element is "located on" a region of a semiconducting substrate, it means that this element is located corresponding to this region in the thickness direction of the semiconducting substrate, and that is, the projection of this element is located in the projection of this region on the plane perpendicular to the thickness direction of the semiconducting substrate.

In the related art of IBC solar cells, grooves are formed between adjacent p-type doped and n-type doped areas to provide spacing effect, preventing current leakage and enhancing the photovoltaic conversion efficiency. However, the structural strength of such solar cells is relatively low, making the solar cells prone to break.

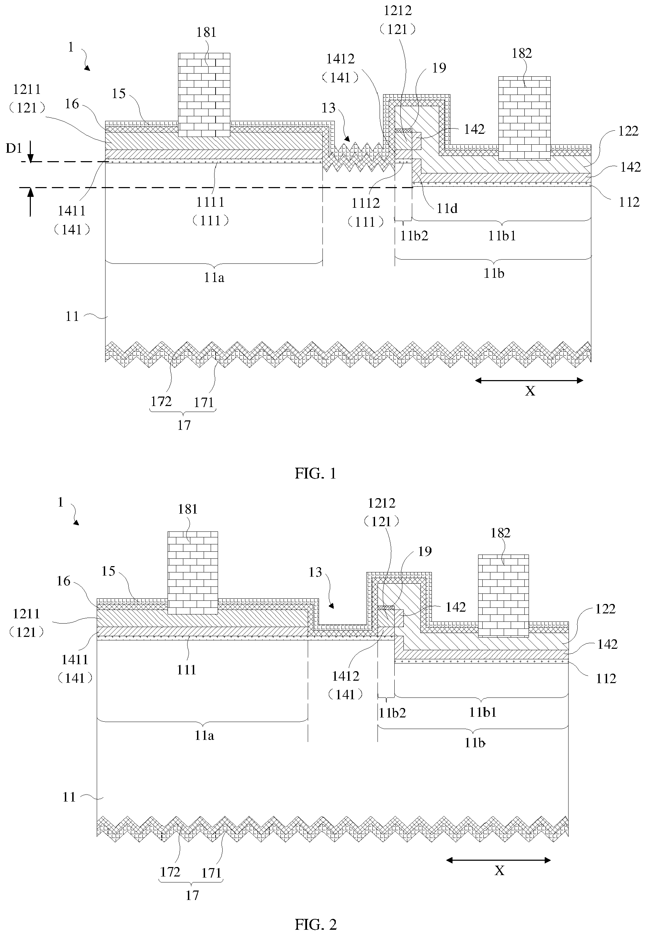

According to a first aspect of the present application, referring to FIGs. 1, 2, 3, and 4A, an embodiment of a solar cell 1 includes a semiconducting substrate 11, a first emitter 121 in a first conductivity type, and a second emitter 122 in a second conductivity type.

The semiconducting substrate 11 includes a first surface and a second surface opposite to each other. The semiconducting substrate 11 includes a first region 11a and a second region 11b spaced from each other in a first direction X. The first direction X is perpendicular to the thickness direction of the semiconducting substrate 11. In use of the solar cell 1, the first surface can be the back surface away from the sun, and the second surface can be the front surface facing the sun. As shown in FIG. 1, in some embodiments, the second surface of the semiconducting substrate 11 can be micro-textured, but is a flat surface as a whole.

Further, the first emitter 121 is disposed on the first surface. The first emitter 121 is provided with a groove 13, which can divide the first emitter 121 into a first sub-emitter 1211 and a second sub-emitter 1212. The first sub-emitter 1211 is located on the first region 11a, and the second sub-emitter 1212 is located on the second region 11b. The second emitter 122 is disposed on the first surface and located on the second region 11b. The minimum distance between the second emitter 122 and the second surface of the semiconducting substrate 11 is less than the minimum distance between the first emitter 121 and the second surface of the semiconducting substrate 11. The groove 13 is located in the first surface of the semiconducting substrate 11. The groove 13 at least penetrates through the first emitter 121, and is located between the first region 11a and the second region 11b.

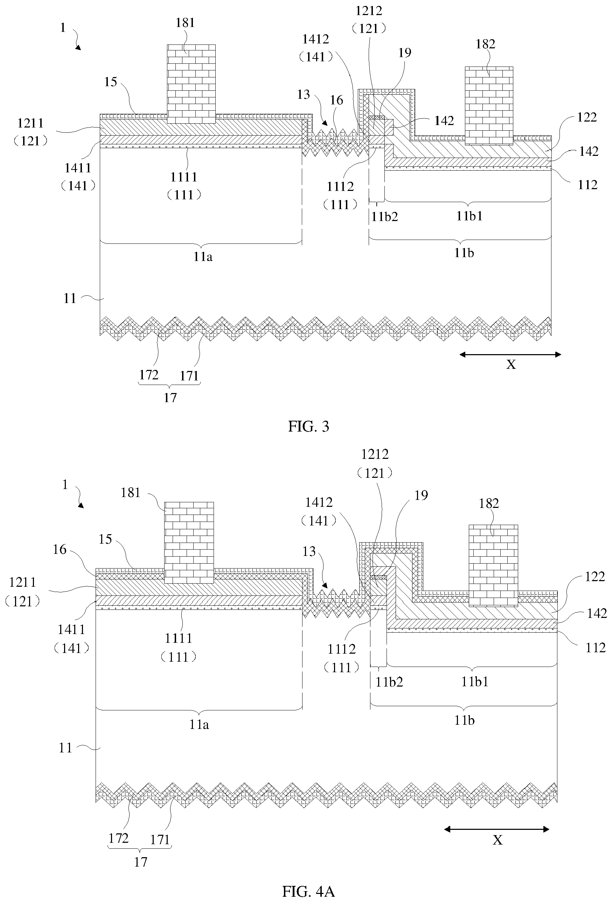

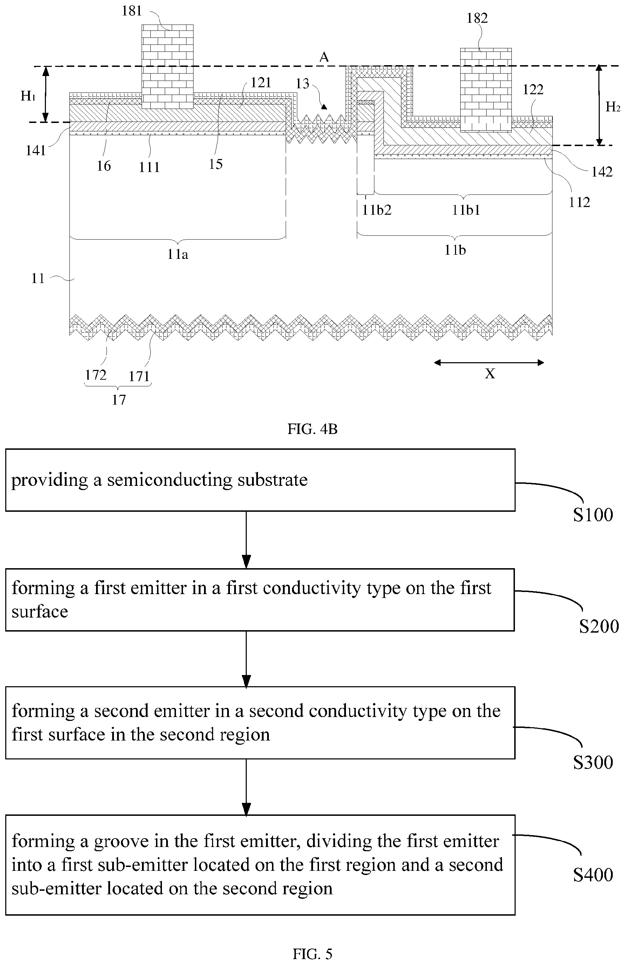

In some embodiments, referring to FIG. 4B, a plane parallel to the first direction X and located at a side of the first and second emitters 121, 122 away from the semiconducting substrate 11 can be defined as common plane A. With respect to the common plane A, the first and second emitters 121, 122 can have depths H1 and H2, respectively. H1 and H2 are respectively distances, along the thickness direction of the semiconducting substrate 11, from the common plane A to the surfaces of the first and second emitters 121, 122 adjacent to the semiconducting substrate 11. H2 is greater than H1, so as to make the minimum distance between the second emitter 122 and the second surface of the semiconducting substrate 11 less than that between the first emitter 121 and the second surface of the semiconducting substrate 11.

It can be understood that one of the first and second conductivity types is the p-type, and the other is the n-type. In some embodiments, the first conductivity type is p-type, the second conductivity type is n-type, and the semiconducting substrate 11 is an n-type semiconductor.

In the solar cell 1 provided in the embodiments of the present application, the groove 13 divides the first emitter 121 into the first sub-emitter 1211 and the second sub-emitter 1212. The first sub-emitter 1211 is located on the first region 11a, and the second sub-emitter 1212 and the second emitter 122 are located on the second region 11b. In other words, the emitter on the first region 11a (i.e., the first sub-emitter 1211) is spaced from the emitter on the second region 11b (i.e., the second sub-emitter 1212 and the second emitter 122) by the groove 13. Thus, on the one hand, the first region 11a is spaced from the second region 11b, which can effectively reduce carrier recombination in the solar cell 1, thereby improving the efficiency of the solar cell 1. On the other hand, in related art, since the minimum distance between the second emitter 122 and the second surface is less than the minimum distance between the first emitter 121 and the second surface, a groove may be formed between the first emitter 121 and the second emitter 122 to completely space the first emitter 121 from the second emitter 122. In order to achieve a good spacing effect, the depth of the groove has to be greater than the depth of the second emitter 122. In contrast, in the embodiments of the present application, since the groove 13 is located in the first emitter 121, as long as the depth of the groove 13 is greater than that of the first emitter 121, the emitter on the first region 11a (i.e., the first sub-emitter 1211) can be spaced from the emitter on the second region 11b (i.e., the second sub-emitter 1212 and the second emitter 122). As a result, the depth of the groove 13 can be effectively reduced, thereby enhancing the structural strength of the solar cell 1 and reducing the risk of breaking the solar cell 1.

In some embodiments, the semiconducting substrate 11 can include a plurality of first regions 11a and a plurality of second regions 11b. The plurality of first regions 11a and the plurality of second regions 11b are arranged alternately along the first direction X. That is, there is one first region 11a between two adjacent second regions 11b, and there is one second region 11b between two adjacent first regions 11a.

Further, a plurality of first emitters 121 and a plurality of second emitters 122 are disposed on the first surface of the semiconducting substrate 11. The plurality of first emitters 121 and the plurality of second emitters 122 are alternately arranged along the first direction X. Further, in the embodiment that two second emitters 122 are respectively arranged at the two sides of one first emitter 121 along the first direction X, two grooves 13 are respectively formed in this first emitter 121. The two grooves 13 divide the first emitter 121 into one first sub-emitter 1211 and two second sub-emitters 1212. The two second sub-emitters 1212 are respectively located at the two sides of the first emitter 121 along the first direction X.

In some embodiments, referring to FIGs. 1, 2, 3 and 4A, the solar cell 1 further includes a first tunneling layer 141 and a second tunneling layer 142. The first tunneling layer 141 is disposed between the first emitter 121 and the semiconducting substrate 11, and the second tunneling layer 142 is disposed between the second emitter 122 and the semiconducting substrate 11. By incorporating the first tunneling layer 141 or the second tunneling layer 142, the interface state density between the semiconducting substrate 11 and the first emitter 121 or between the semiconducting substrate 11 and the second emitter 122 can be reduced, thereby reducing the carrier recombination and enhancing the efficiency of the solar cell 1.

It can be understood that as the first tunneling layer 141 is disposed on the side of the first emitter 121 adjacent to the semiconducting substrate 11, the groove 13 can either penetrate through the first tunneling layer 141 or not, which is not limited herein.

In some embodiments, the groove 13 penetrates through the first tunneling layer 141, thus dividing the first tunneling layer 141 into a first part 1411 located on the first region 11a and a second part 1412 located on the second region 11b. Thus, on the one hand, a relatively good spacing effect can be achieved between the first region 11a and the second region 11b; on the other hand, during the wet etching with an etchant to form the groove 13, there is no need to protect the first tunneling layer 141 from being etched, which is conducive to complete removal of the first emitter 121 from the groove 13 and reducing the difficulty of the etching process.

It can be understood that when there are two grooves 13 formed in a same first emitter 121, both grooves 13 can penetrate through the first tunneling layer 141, thus dividing the first tunneling layer 141 into one first part 1411 and two second parts 1412. Alternatively, only one of the two grooves 13 penetrates through the first tunneling layer 141, thus dividing the first tunneling layer 141 into one first part 1411 and one second part 1412.

In another embodiment, the groove 13 does not extend into the first tunneling layer 141, and thus the depth of the groove 13 can be reduced, thereby improving the structural strength of the solar cell 1, and further reducing the risk of breaking the solar cell 1. Alternatively, the groove 13 can extend into the first tunneling layer 141 but does not penetrate through the first tunneling layer 141.

In some embodiments, the second region 11b includes a first sub-region 11b1 and a second sub-region 11b2 arranged adjacent to each other along the first direction X. The second sub-region 11b2 is located at a side of the first sub-region 11b1 adjacent to the first region 11a and the groove 13. The first surface of the semiconducting substrate 11 in the first region 11a and the first surface of the semiconducting substrate 11 in the second sub-region 11b2 can be located in the same plane. With respect to this plane, the first sub-region 11b1 can be recessed to have a recess depth D1, which is defined as a distance, along the thickness direction of the semiconducting substrate 11, between the first surface in the second sub-region 11b2 and the first surface in the first sub-region 11b1. Thus, a step can be formed between the second sub-region 11b2 and the first sub-region 11b1, such that the semiconducting substrate 11 includes a sidewall 11d between the second sub-region 11b2 and the first sub-region 11b1. The second part 1412 of the first tunneling layer 141 covers the first surface of the semiconducting substrate 11 in second sub-region 11b2. The second tunneling layer 142 at least covers the first surface of the semiconducting substrate 11 in the first sub-region 11b1 and the sidewall of the second sub-emitter 1212 that is away from the groove 13.

In preparation of the solar cell 1, the first emitter 121 and the first tunneling layer 141 can be formed first, and then the second tunneling layer 142 and the second emitter 122 are formed. Since the second tunneling layer 142 covers the sidewall of the second sub-emitter 1212 away from the groove 13, the processing accuracy can be reduced, thereby reducing the production cost of the solar cell 1.

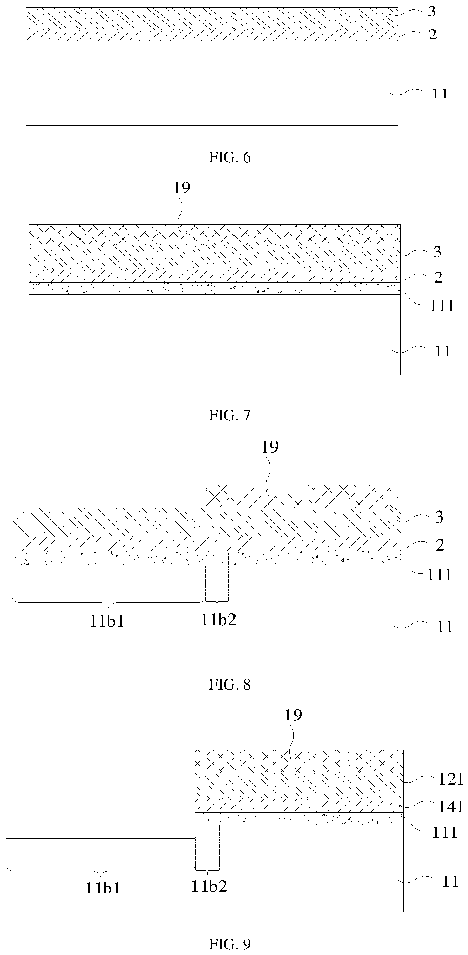

In some embodiments, the minimum distance between the second tunneling layer 142 located on the first sub-region 11b1 and the second surface is less than the minimum distance between the first part 1411 and the second surface. In other words, with respect to the common plane A, the depth of the second tunneling layer 142 located on the first sub-region 11b1 is greater than the depth of the first part 1411. It can be understood that before forming the second tunneling layer 142, a first tunneling material layer 2 on the first sub-region 11b1 may be removed using wet etching, such that a part of a semiconducting substrate material in the first sub-region 11b1 is also removed, e.g., as shown in FIGs. 8 and 9. As a result, the second tunneling layer 142 on the first sub-region 11b1 may have a greater depth than that of the first tunneling layer 141.

In some embodiments, referring to FIG. 4A, the second tunneling layer 142 can further cover the sidewall of the second part 1412 away from the groove 13 and the surface of the second sub-emitter 1212 away from the semiconducting substrate 11. Thus, the second tunneling layer 142 can be formed as a continuous structure by using a film deposition method, covering the entire from the surface of the second sub-emitter 1212 away from the semiconducting substrate 11 to the first surface of the semiconducting substrate 11 in the first sub-region 11b1, including entire of the sidewalls of the layers on the second sub-region 11b2 and the sidewall 11d of the semiconducting substrate 11.

In some embodiments, as shown in FIG. 4A, the second tunneling layer 142 can be in a Z-shape.

In some embodiments, the surface of the second sub-emitter 1212 away from the semiconducting substrate 11 is covered with a first silicon oxide dielectric layer 19, and the second tunneling layer 142 covers the surface of the first silicon oxide dielectric layer 19 away from the semiconducting substrate 11. In other words, the first silicon oxide dielectric layer 19 is sandwiched between the second sub-emitter 1212 and the second tunneling layer 142 on the second sub-region 11b2.

In some embodiments, referring to FIGs. 1, 2, and 3, the second emitter 122 covers the sidewall of the second part 1412 away from the groove 13 and the surface of the second sub-emitter 1212 away from the semiconducting substrate 11. When the second tunneling layer 142 is formed by using a thermal oxidation method, the second tunneling layer 142 cannot be grown from the sidewall of the second part 1412, thus leaving the sidewall of the second part 1412 exposed. After the second emitter 122 is formed, the sidewall of the second part 1412 can be directly covered by the second emitter 122.

In some embodiments, the surface of the second sub-emitter 1212 away from the semiconducting substrate 11 is covered with the first silicon oxide dielectric layer 19, and the second emitter 122 covers the surface of the first silicon oxide dielectric layer 19 away from the semiconducting substrate 11.

Further, referring to FIGs. 1, 2, and 3, the second tunneling layer 142 breaks at the sidewall of the second part 1412 away from the groove 13, and thus is divided into two spaced sections. One section of the second tunneling layer 142 has an L-shape structure, which covers the first surface of the semiconducting substrate 11 in the first sub-region 11b1 and covers the sidewall 11d of the semiconducting substrate 11. The other section of the second tunneling layer 142 covers the sidewall of the second sub-emitter 1212 away from the groove 13.

In some embodiments, an orthogonal projection of the second part 1412 on the semiconducting substrate 11 covers the second sub-region 11b2.

In some embodiments, an orthogonal projection of the second emitter 122 on the semiconducting substrate 11 covers the first sub-region 11b1 and at least part of the second sub-region 1 1b2. It can be understood that the orthogonal projection of the second emitter 122 on the semiconducting substrate 11 can cover part of the second sub-region 11b2, or can cover the entire second sub-region 11b2.

In some embodiments, sizes of the second part 1412 and the second tunneling layer 142 satisfy 0<X1/X2≤1/10, wherein X1 is the size of the second part 1412 along the first direction X, and X2 is the size of the second tunneling layer 142 on the first sub-region 11b1 along the first direction X. Thus, on the one hand, it can be ensured that the groove 13 is located in the first emitter 121, so that the depth of the groove 13 can be reduced while the spacing effect of the groove 13 can be achieved. On the other hand, the area of the second part 1412 can be reduced, thereby reducing the carrier recombination in the solar cell 1.

In some embodiments, sizes of the second sub-region 11b2 and the first sub-region 11b1 satisfy 0<X3/X4≤1/10, wherein X3 is the size of the second sub-region 11b2 along the first direction X, and X4 is the size of the first sub-region 11b1 along the first direction X.

In some embodiments, referring to FIGs. 1, 3, 4A, and 4B, the groove 13 extends into the semiconducting substrate 11, which means that along the thickness direction of the semiconducting substrate 11, the distance between the first surface of the semiconducting substrate 11 in the groove 13 and the common plane A is less than the distance between the first surface of the semiconducting substrate 11 in the first region 11a and the common plane A. Thus, on the one hand, the spacing effect of the groove 13 between the first region 11a and the second region 11b can be further enhanced, effectively reducing carrier recombination in the solar cell 1; on the other hand, during the formation of the groove 13, there is no need to protect the semiconducting substrate 11 from being etched, which is conducive to complete removal of the first emitter 121 from the groove 13 and reducing the difficulty of the etching process. In some embodiments, the first surface of the semiconducting substrate 11 in the groove 13 can be micro-textured.

In some embodiments, referring to FIG. 2, the groove 13 does not extend into the semiconducting substrate 11. As a result, the depth of the groove 13 can be reduced, thus enhancing the structural strength of the solar cell 1, and decreasing the risk of breakage of the solar cell 1.

In some embodiments, the distance between the second tunneling layer 142 located on the first sub-region 11b1 and the second surface is less than or equal to the distance between the bottom surface of the groove 13, formed by the first surface of the semiconducting substrate 11 in the groove 13, and the second surface. That is, the depth of the groove 13 is less than or equal to the depth of the second tunneling layer 142 on the first sub-region 11b1. It can be noted that in the related art, a groove may be formed between a first emitter 121 and a second emitter 122 for spacing the two emitters. In order to achieve a good spacing effect, the depth of the groove may be greater than the depth of the second emitter 122. In contrast, in the embodiments of the present application, the groove 13 is formed in the first emitter 121, and thus the depth of the groove 13 only needs to be greater than the depth of the first emitter 121 to space the emitter on the first region 11a (i.e., the first sub-emitter 1211) from the emitters on the second region 11b (i.e., the second sub-emitter 1212 and the second emitter 122). As a result, the depth of the groove 13 can be effectively reduced, thereby enhancing the structural strength of the solar cell 1 and reducing the risk of breaking the solar cell 1.

In some embodiments, referring to FIGs. 1, 2, 3, and 4A, a first dielectric layer 15 is disposed on the side of the first emitter 121 away from the semiconducting substrate 11 and on the side of the second emitter 122 away from the semiconducting substrate 11. The first dielectric layer 15 further covers the groove 13. In some embodiments, the first dielectric layer 15 is made of silicon nitride.

Thus, the first dielectric layer 15, on the one hand, can form protection on the first surface of the semiconducting substrate 11, and, on the other hand, can be an anti-reflection layer.

In some embodiments, referring to FIGs. 3 and 4A, the solar cell 1 further includes a first passivation layer 16, which at least covers the sidewalls and the bottom surface of the groove 13, thus ensuring a good passivation effect at the area of the groove 13.

In some embodiments, the first passivation layer 16 is made of aluminum oxide.

In some embodiments, referring to FIG. 3, the first passivation layer 16 only covers the sidewalls and the bottom surface of the groove 13. In other words, the sides of the first emitter 121 and the second emitter 122 away from the semiconducting substrate 11 are not covered with the first passivation layer 16. Thus, during the sintering of the electrodes, the electrodes only needs to penetrate through the first dielectric layer 15, so that the content of glass frit, which acts as an etchant in the electrode paste, can be reduced, thereby reducing the etch damage to the first emitter 121 and the second emitter 122 caused by the glass frit.

In some embodiments, referring to FIG. 4A, the first passivation layer 16 further covers the surface of the first sub-emitter 1211 away from the semiconducting substrate 11 and the surface of the second emitter 122 away from the semiconducting substrate 11. As such, on the one hand, a good passivation effect on the first surface of the solar cell 1 can be provided; on the other hand, compared to that with the first passivation layer 16 only covering the groove 13, the manufacturing difficulty of the solar cell 1 can be reduced.

In some embodiments, referring to FIGs. 1, 2, 3, and 4A, the semiconducting substrate 11 includes a first diffusion region 111 and a second diffusion region 112, both extending from the first surface towards the second surface. The orthogonal projection of the first emitter 121 on the semiconducting substrate 11 covers at least a part of the first diffusion region 111, and the orthogonal projection of the second emitter 122 on the semiconducting substrate 11 covers at least a part of the second diffusion region 112.

In some embodiments, referring to FIGs. 1, 3, and 4A, the first diffusion region 111 includes a first sub-diffusion region 1111 and a second sub-diffusion region 1112 spaced from each other in the first direction X. The orthogonal projection of the first sub-emitter 1211 on the semiconducting substrate 11 coincides with the first sub-diffusion region 1111, and the orthogonal projection of the second sub-emitter 1212 on the semiconducting substrate 11 coincides with the second sub-diffusion region 1112. There is no diffusion region under the groove 13, thus providing good spacing effect between the first region 11a and the second region 11b, effectively reducing carrier recombination, thereby enhancing the efficiency of the solar cell 1.

In some embodiments, referring to FIG. 2, the first diffusion region 111 can further extend under the groove 13.

In some embodiments, the size of the first sub-emitter 1211 along the first direction X is greater than or equal to the size of the second emitter 122 along the first direction X. In this way, the area occupied by the first sub-emitter 1211 is greater than the area occupied by the second emitter 122, and a p-n junction formed between the first sub-emitter 1211 and the semiconducting substrate 11 is more conducive to collecting current carriers, thereby improving the efficiency of the solar cell 1.

In some embodiments, the orthogonal projection area of the first sub-emitter 1211 on the semiconducting substrate 11 is greater than or equal to the orthogonal projection area of the second emitter 122 on the semiconducting substrate 11. As the p-n junction is formed between the first sub-emitter 1211 and the semiconducting substrate 11, the larger area of the first sub-emitter 1211 is more conducive to collecting current carriers, thereby enhancing the efficiency of the solar cell 1.

In some embodiments, referring to FIGs. 1, 3, and 4A, the bottom surface of the groove 13 has a micro-textured structure, which can improve the efficiency of light collection.

Alternatively, in some other embodiments, referring to FIG. 2, the bottom surface of the groove 13 can be a flat surface.

In some embodiments, referring to FIGs. 1 to 4B, the solar cell 1 further includes a first electrode 181 and a second electrode 182. The first electrode 181 can penetrate through the first dielectric layer 15 to be electrically connected to the first emitter 121, and the second electrode 182 can penetrate through the first dielectric layer 15 to be electrically connected to the second emitter 122. In some embodiments, the first electrode 181 can penetrate through both the first dielectric layer 15 and the first passivation layer 16 to be electrically connected to the first emitter 121, and the second electrode 182 can penetrate through both the first dielectric layer 15 and the first passivation layer 16 to be electrically connected to the second emitter 122.

In some embodiments, the solar cell 1 further includes a passivation layer group 17 disposed on the second surface of the semiconducting substrate 11. In some embodiments, the passivation layer group 17 includes an anti-reflection layer 171 and a second passivation layer 172 stacked with each other. The second passivation layer 172 is disposed between the semiconducting substrate 11 and the anti-reflection layer 171.

It can be understood that a plurality of first emitters 121 and a plurality of second emitters 122 can be disposed on the semiconducting substrate 11. The plurality of first emitters 121 and the plurality of second emitters 122 are alternately arranged along the first direction X. Each first emitter 121 is electrically connected to one corresponding first electrode 181, and each second emitter 122 is electrically connected to one corresponding second electrode 182.

According to a second aspect of the present application, referring to FIG. 5, an embodiment of a method for preparing a solar cell is provided. The method can be used to prepare the solar cell 1 described in the first aspect. Specifically, the preparation method includes S100 and S200.

In S100, a semiconducting substrate 11 is provided. The semiconducting substrate 11 includes a first surface and a second surface opposite to each other. The semiconducting substrate 11 includes a first region 11a and a second region 11b spaced from each other in a first direction X. The first direction X is perpendicular to the thickness direction of the semiconducting substrate 11. Exemplarily, the semiconducting substrate 11 can be made of silicon.

It can be understood that, in S100, a cleaning solution can be used to remove contaminants from the semiconducting substrate 11. In an embodiment, the cleaning solution is an alkaline solution.

In S200, a first emitter 121 in a first conductivity type is formed on the first surface.

In S300, a second emitter 122 in a second conductivity type is formed on the first surface in the second region 11b. The minimum distance between the second emitter 122 and the second surface of the semiconducting substrate 11 is less than the minimum distance between the first emitter 121 and the second surface of the semiconducting substrate 11.

In S400, a groove 13 is formed in the first emitter 121, which divides the first emitter 121 into a first sub-emitter 1211 located on the first region 11a and a second sub-emitter 1212 located on the second region 11b.

It can be understood that one of the first and second conductivity types is the p-type, and the other is the n-type. In some embodiments, the first conductivity type is p-type, the second conductivity type is n-type, and the semiconducting substrate 11 is an n-type semiconductor.

In the preparation method of the solar cell 1 provided in the embodiments of the present application, the groove 13 is formed to divide the first emitter 121 into the first sub-emitter 1211 and the second sub-emitter 1212. The first sub-emitter 1211 is located on the first region 11a, and the second sub-emitter 1212 and the second emitter 122 are located on the second region 11b. In other words, the emitter on the first region 11a (i.e., the first sub-emitter 1211) is spaced from the emitter on the second region 11b (i.e., the second sub-emitter 1212 and the second emitter 122) by the groove 13. Thus, on the one hand, the first region 11a is spaced from the second region 11b, which can effectively reduce carrier recombination in the solar cell 1, thereby improving the efficiency of the solar cell 1. On the other hand, in related art, since the minimum distance between the second emitter 122 and the second surface is less than the minimum distance between the first emitter 121 and the second surface, a groove may be formed between the first emitter 121 and the second emitter 122 to completely space the first emitter 121 from the second emitter 122. In order to achieve a good spacing effect, the depth of the groove has to be greater than the depth of the second emitter 122. In contrast, in the embodiments of the present application, since the groove 13 is formed in the first emitter 121, as long as the depth of the groove 13 is greater than that of the first emitter 121, the emitter on the first region 11a (i.e., the first sub-emitter 1211) can be spaced from the emitter on the second region 11b (i.e., the second sub-emitter 1212 and the second emitter 122). As a result, the depth of the groove 13 can be effectively reduced, thereby enhancing the structural strength of the solar cell 1 and reducing the risk of breaking the solar cell 1.

In some embodiments, referring to FIGs. 6, 7, 8, and 9, the second region 11b includes a first sub-region 11b1 and a second sub-region 11b2 arranged adjacent to each other along the first direction X. In some embodiments, S200 specifically includes S210 and S220.

In S210, a first tunneling material layer 2, a first emitter material layer 3, and a first silicon oxide dielectric layer 19 are formed to stack on the first surface of the semiconducting substrate 11, and the semiconducting substrate 11 with the stacked layers is subjected to a first heat treatment.

Exemplarily, the first tunneling material layer 2 can be formed by using a plasma oxidation method or a thermal oxidation method. Exemplarily, the first emitter material layer 3 can be formed by one of the following two methods. In the first method, the first emitter material layer 3 is formed by using plasma enhanced chemical vapor deposition (PECVD), and the first emitter material layer 3 can be formed to contain a doping element (such as boron or phosphorus); then, the first silicon oxide dielectric material layer 19 is deposited on the first emitter material layer 3 by using PECVD. In the second method, the first emitter material layer 3 is formed by using low pressure chemical vapor deposition (LPCVD), and the first emitter material layer 3 may contain or not contain any doping element (such as boron or phosphorus).

Exemplarily, the first heat treatment can be carried out at a temperature ranging from 700°C to 1100°C. If the first emitter material layer 3 is formed using the first method as described above, the first heat treatment activates the doping element (such as boron or phosphorus) contained in the first emitter material layer 3, with the first silicon oxide dielectric material layer 19 serving as a protection. If the first emitter material layer 3 is formed using the second method as described above, there can be two further scenarios. On the condition that the first emitter material layer 3 contains a doping element (such as boron or phosphorus), the first heat treatment not only activates the doping element (such as boron or phosphorus), but also forms a first silicon oxide dielectric material layer 19 due to the high-temperature oxidation by the first heat treatment. On the condition that the first emitter material layer 3 does not contain any doping element (such as boron or phosphorus), the doping element can be externally introduced into the first emitter material layer 3 during the first heat treatment, for example, through boron diffusion or phosphorus diffusion, and thus the first silicon oxide dielectric material layer 19 also can be formed during the first heat treatment.

In some embodiments, the first tunneling material layer 2 is made of silicon oxide, and the initially deposited first emitter material layer 3 is made of a mixture of microcrystalline silicon and amorphous silicon. During the first heat treatment, the mixture of microcrystalline silicon and amorphous silicon further crystallizes to form a crystallized silicon material layer containing a dopant. It can be understood that in the first heat treatment, the dopant can diffuse into the semiconducting substrate 11 through the first tunneling material layer 2, thus forming the first diffusion region 111 in the semiconducting substrate 11 under the first tunneling material layer 2.

In S220, the first silicon oxide dielectric material layer 19, the first emitter material layer 3, and the first tunneling material layer 2 on the first sub-region 11b1 are removed. In some embodiments, referring to FIGs. 8 and 9, the first silicon oxide dielectric layer 19 on the first sub-region 11b1 is firstly removed by laser etching, and then the first emitter material layer 3, the first tunneling material layer 2, and the first diffusion region 111 on the first sub-region 11b1 are removed by wet etching with a first etchant. Exemplarily, the first etchant can be an alkaline etching solution.

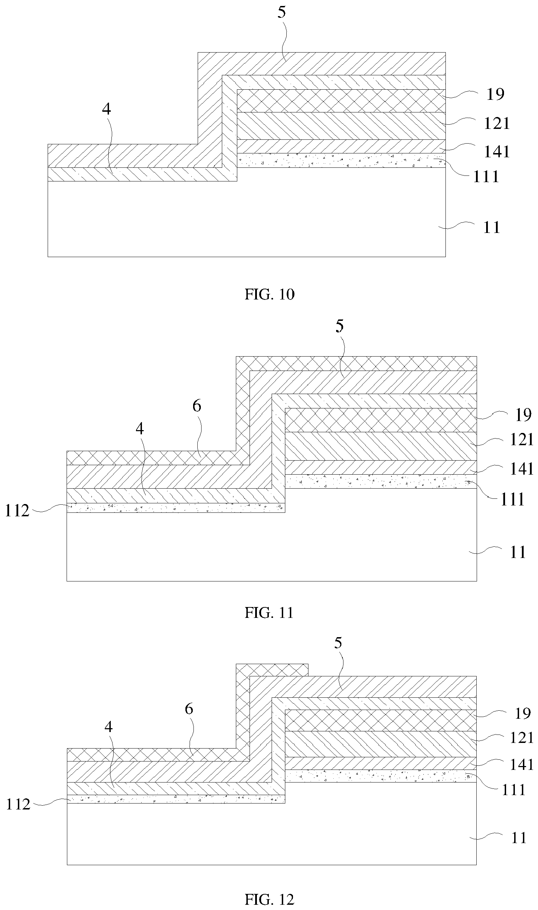

In some embodiments, referring to FIGs. 10, 11, 12, and 13, S300 specifically includes S310 and S320.

In S310, a second tunneling material layer 4, a second emitter material layer 5, and a second silicon oxide dielectric layer 6 are formed to stack on the first surface of the semiconducting substrate 11, and the semiconducting substrate 11 with the stacked layers is subjected to a second heat treatment.

Exemplarily, the second tunneling material layer 4 can be formed by using a plasma oxidation method or a thermal oxidation method. Exemplarily, the second emitter material layer 5 can be formed by one of the following two methods. In the first method, the first emitter material layer 5 is formed by using plasma enhanced chemical vapor deposition (PECVD), and the first emitter material layer 5 can be formed to contain a doping element, which is different from the doping element contained in the first emitter material layer 3 in doping type. For example, when the doping element of the first emitter material layer 3 is boron, the doping element of the second emitter material layer 5 is phosphorus, and vice versa. Then, the second silicon oxide dielectric material layer 6 is deposited on the second emitter material layer 5 by using PECVD. In the second method, the second emitter material layer 5 is formed by using low pressure chemical vapor deposition (LPCVD), and the second emitter material layer 5 may contain or not contain any doping element. The doping element contained in the second emitter material layer 5 is different from the doping element contained in the first emitter material layer 3 in doping type. For example, when the doping element of the first emitter material layer 3 is boron, the doping element of the second emitter material layer 5 is phosphorus, and vice versa.

Exemplarily, the second heat treatment can be carried out at a temperature ranging from 700°C to 1100°C. If the second emitter material layer 5 is formed using the first method as described above, the second heat treatment activates the doping element (such as boron or phosphorus) contained in the second emitter material layer 5, with the second silicon oxide dielectric material layer 6 serving as a protection. If the second emitter material layer 5 is formed using the second method as described above, there can be two further scenarios. On the condition that the second emitter material layer 5 contains a doping element (such as boron or phosphorus), the second heat treatment not only activates the doping element (such as boron or phosphorus), but also forms a second silicon oxide dielectric material layer 6 due to the high-temperature oxidation by the second heat treatment. On the condition that the second emitter material layer 5 does not contain any doping element (such as boron or phosphorus), the doping element can be externally introduced into the second emitter material layer 5 during the second heat treatment, for example, through boron diffusion or phosphorus diffusion, noting that the doping element introduced into the second emitter material layer 5 is different from the doping element introduced into the first emitter material layer 3 in doping type, and thus the second silicon oxide dielectric material layer 6 also can be formed during the second heat treatment.

In some embodiments, the second tunneling material layer 4 is made of silicon oxide, and the initially deposited second emitter material layer 5 is made of a mixture of microcrystalline silicon and amorphous silicon. During the second heat treatment, the mixture of microcrystalline silicon and amorphous silicon further crystallizes to form a crystallized silicon material layer containing a dopant. It can be understood that in the second heat treatment, the dopant can diffuse into the semiconducting substrate 11 through the second tunneling material layer 4, thus forming the second diffusion region 112 in the semiconducting substrate 11 under the second tunneling material layer 4.

In S320, the second silicon oxide dielectric layer 6, the second emitter material layer 5, and the second tunneling material layer 4 on the first region 11a and the spacing region 11c are removed. The region of the semiconducting substrate 11 between the first region 11a and the second region 11b is defined as the spacing region 11c.

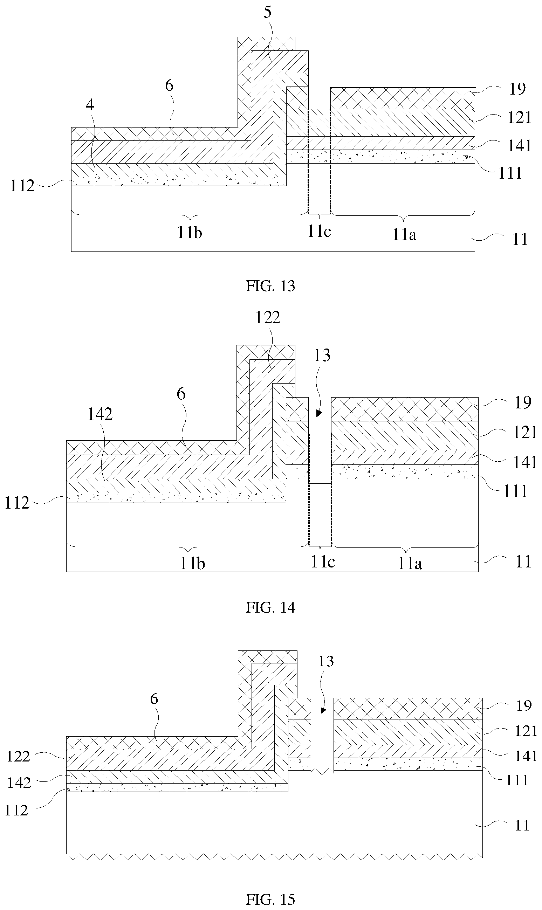

In some embodiments, referring to FIGs. 12 and 13, the second silicon oxide dielectric layer 6 on the first region 11a and the spacing region 11c is firstly removed by laser etching, and then the second emitter material layer 5 and the second tunneling material layer 4 on the first region 11a and the spacing region 11c are removed by wet etching with a second etchant. Exemplarily, the second etchant can be an alkaline etching solution.

In some embodiments, referring to FIGs. 13 and 14, in S400, the first silicon oxide dielectric layer 19 on the spacing region 11c is firstly removed by laser etching, thereby defining an etching window for the groove 13. Then, the first emitter 121 and the first tunneling layer 141, and optionally the first diffusion region 111, that are exposed from the first silicon oxide dielectric layer 19 are removed by wet etching with a third etchant. The third etchant contains a polishing additive. Exemplarily, the third etchant contains KOH and tetramethylammonium hydroxide (TMAH).

In some embodiments, referring to FIGs. 15, 16, and 17, after S400, the method can further include S500 to S800.

In S500, the second surface of the semiconducting substrate 11 and the bottom surface of the groove 13 are formed into a micro-textured structure, which may include continuously arranged pyramids. Exemplarily, the micro-textured structure is formed by treating the surfaces with an alkaline etching solution containing a texturing additive. In an embodiment, the alkaline etching solution includes KOH and TMAH.

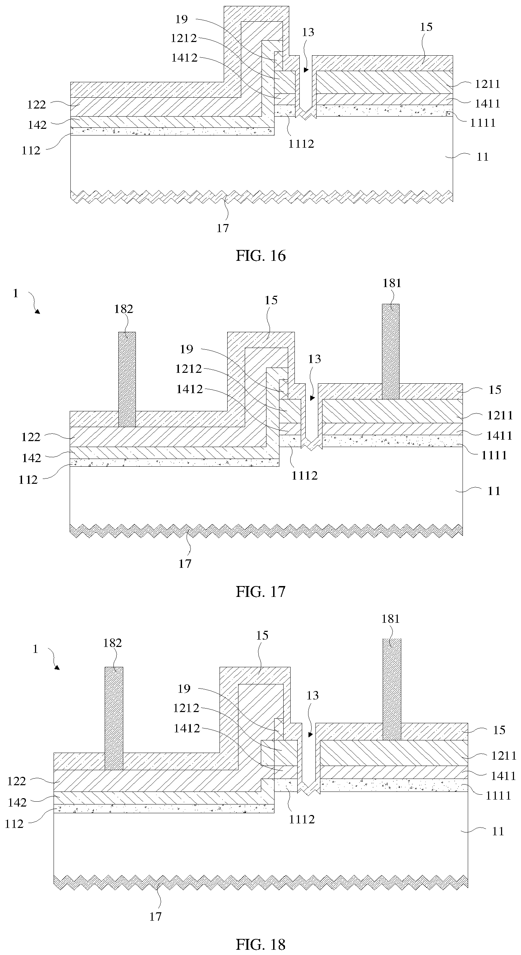

In S600, the first silicon oxide dielectric layer 19 and the second silicon oxide dielectric layer 6 on the first surface are removed. It can be noted that, referring to FIG. 16, since the second tunneling layer 142 covers part of the first silicon oxide dielectric layer 19, that part of the first silicon oxide dielectric layer 19 remains on the second sub-emitter 1212. In some embodiments, the first silicon oxide dielectric layer 19 and the second silicon oxide dielectric layer 6 can be removed with hydrogen fluoride.

In S700, the first dielectric layer 15 is formed on the first surface, and a passivation layer group 17 is formed on the second surface. It can be noted that, a first passivation layer 16 can be further formed on the first surface, between the first dielectric layer 15 and the semiconducting substrate 11. In some embodiments, the passivation layer group 17 can include an anti-reflection layer 171 and a second passivation layer 172. The second passivation layer 172 is located between the anti-reflection layer 171 and the semiconducting substrate 11.

In S800, the first electrode 181 and the second electrode 182 are formed on the first surface. Specifically, conductive pastes can be printed in the areas corresponding to the first and second emitters 121, 122 and then sintered. During the sintering process, the first and second electrodes 181, 182 burn through the first dielectric layer 15 to make contact with the first emitter 121 and the second emitter 122, respectively.

It can be noted that FIGs. 6 to 17 are sectional partial views showing the preparation process of the solar cell 1, in which the second tunneling layer 142 is formed by chemical vapor deposition, covering the sidewall and top surfaces of the first silicon oxide dielectric layer 19, as well as covering the sidewall of the second part 1412 away from the groove 13.

FIG. 18 is a schematic structural sectional partial view of another solar cell 1 after preparation process. In the preparation process of this solar cell 1, the second tunneling layer 142 is formed by using a thermal oxidation method or a plasma oxidation method, covering the semiconducting substrate 11 in the first sub-region 11b1, as well as covering the sidewall of the second sub-emitter 1212 away from the groove 13. The second tunneling layer 142 breaks at the sidewall of the second part 1412 away from the groove 13. The sidewall and the top surface of the first silicon oxide dielectric layer 19 are not covered by the second tunneling layer 142.

It should be understood that, in the method of the embodiments of the present application, at least some of the steps can include multiple sub-steps or multiple stages, these sub-steps or stages are not necessarily performed at the same time, but may be performed at different times. These sub-steps or stages are not necessarily to be sequentially performed, but can be performed alternately or in turn with at least some of the sub-steps or stages of other steps.

According to a third aspect of the present application, an embodiment of a photovoltaic module includes the solar cell described in any of the embodiments of the first aspect.

Exemplarily, the photovoltaic module includes a plurality of solar cells, which can be connected in series through welding strips, thereby aggregating the electrical energy generated by individual solar cells for subsequent transmission. Specifically, the first electrodes of each solar cell are electrically connected to the second electrodes of an adjacent solar cell by welding strips, and the second electrodes of each solar cell are electrically connected to the first electrodes of another adjacent solar cell by conductive strips, so that the solar cells are connected in series. The solar cells can be arranged at intervals, or can be stacked together in an imbricated form.

Furthermore, the photovoltaic module further includes an encapsulation layer and a cover plate (not shown). The encapsulation layer is configured to cover the surface of the solar cells connected in series. The cover plate is configured to cover the surface of the encapsulation layer away from the solar cells. The solar cells are electrically connected to form a whole piece or multiple pieces, such as forming a plurality of cell groups. The plurality of cell groups are electrically connected in series and/or in parallel. Specifically, in some embodiments, the plurality of cell groups can be electrically connected through conductive strips. The encapsulation layer covers the surface of the solar cells. Exemplarily, the encapsulation layer can be an organic encapsulation film, such as an ethylene-vinyl acetate copolymer film, a polyethylene-octene elastomer film, or a polyethylene terephthalate film. The cover plate can have a light-transmitting function, such as a glass cover plate, a plastic cover plate, or the like.

In the photovoltaic module provided in the embodiments of the present application, the groove 13 divides the first emitter 121 of the solar cell 1 into the first sub-emitter 1211 and the second sub-emitter 1212. The first sub-emitter 1211 is located on the first region 11a, and the second sub-emitter 1212 and the second emitter 122 are located on the second region 11b. In other words, the emitter on the first region 11a (i.e., the first sub-emitter 1211) is spaced from the emitter on the second region 11b (i.e., the second sub-emitter 1212 and the second emitter 122) by the groove 13. Thus, on the one hand, the first region 11a is spaced from the second region 11b, which can effectively reduce carrier recombination in the solar cell 1, thereby improving the efficiency of the solar cell 1. On the other hand, on the condition that the minimum distance between the second emitter 122 and the second surface is less than the minimum distance between the first emitter 121 and the second surface, in related art, a groove may be formed between the first emitter 121 and the second emitter 122 to completely space the first emitter 121 from the second emitter 122. In order to achieve a good spacing effect, the depth of the groove may be greater than the depth of the second emitter 122. In contrast, in the embodiments of the present application, the groove 13 is located in the first emitter 121 and penetrates through the first emitter 13, so that the emitter on the first region 11a (i.e., the first sub-emitter 1211) can be spaced from the emitter on the second region 11b (i.e., the second sub-emitter 1212 and the second emitter 122). As a result, the depth of the groove 13 can be effectively reduced, thereby enhancing the structural strength of the solar cell 1 and reducing the risk of breaking the solar cell 1.

According to a fourth aspect of the present application, an embodiment of a photovoltaic system includes the photovoltaic module in the third aspect.

The photovoltaic system can be applied to photovoltaic power stations, such as ground power stations, roof power stations, water surface power stations, etc. Alternatively, the photovoltaic system can be applied to equipment or devices that use solar energy to generate electricity, such as user solar power supplies, solar street lights, solar cars, solar buildings, etc. It can be understood that the application scenarios of the photovoltaic system are not limited to the above, that is, the photovoltaic system can be applied in all fields that need to use solar energy to generate electricity. Taking a photovoltaic power generation network as an example, the photovoltaic system can include photovoltaic arrays, a combiner box, and an inverter. The photovoltaic array can be an array of multiple photovoltaic modules. For example, the multiple photovoltaic modules can form multiple photovoltaic arrays. The photovoltaic arrays are connected to the combiner box, which can combine the currents generated by the photovoltaic arrays. The combined current flows through the inverter and is converted into the alternating current suitable for the power grid, and then connected to the power grid to realize solar power supply.

In the photovoltaic system provided in the embodiments of the present application, the groove 13 divides the first emitter 121 of the solar cell 1 into the first sub-emitter 1211 and the second sub-emitter 1212. The first sub-emitter 1211 is located on the first region 11a, and the second sub-emitter 1212 and the second emitter 122 are located on the second region 11b. In other words, the emitter on the first region 11a (i.e., the first sub-emitter 1211) is spaced from the emitter on the second region 11b (i.e., the second sub-emitter 1212 and the second emitter 122) by the groove 13. Thus, on the one hand, the first region 11a is spaced from the second region 11b, which can effectively reduce carrier recombination in the solar cell 1, thereby improving the efficiency of the solar cell 1. On the other hand, on the condition that the minimum distance between the second emitter 122 and the second surface is less than the minimum distance between the first emitter 121 and the second surface, in related art, a groove may be formed between the first emitter 121 and the second emitter 122 to completely space the first emitter 121 from the second emitter 122. In order to achieve a good spacing effect, the depth of the groove may be greater than the depth of the second emitter 122. In contrast, in the embodiments of the present application, the groove 13 is located in the first emitter 121 and penetrates through the first emitter 13, so that the emitter on the first region 11a (i.e., the first sub-emitter 1211) can be spaced from the emitter on the second region 11b (i.e., the second sub-emitter 1212 and the second emitter 122). As a result, the depth of the groove 13 can be effectively reduced, thereby enhancing the structural strength of the solar cell 1 and reducing the risk of breaking the solar cell 1.

The technical features of the above embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A solar cell, comprising:
a semiconducting substrate (11) comprising a first surface and a second surface opposite to each other, the semiconducting substrate (11) comprising a first region (11a) and a second region (11b) spaced apart from each other in a first direction (X), the first direction (X) being perpendicular to a thickness direction of the semiconducting substrate (11);
a first emitter (121) in a first conductivity type, the first emitter (121) being disposed on the first surface and comprising a groove (13), the groove (13) dividing the first emitter (121) into a first sub-emitter (1211) and a second sub-emitter (1212), the first sub-emitter (1211) being located on the first region (11a), the second sub-emitter (1212) being located on the second region (11b); and
a second emitter (122) in a second conductivity type, the second emitter (122) being disposed on the first surface and located on the second region (11b);
wherein the minimum distance between the second emitter (122) and the second surface is less than the minimum distance between the first emitter (121) and the second surface.

2. The solar cell according to claim 1, further comprising:
a first tunneling layer (141) disposed between the first emitter (121) and the semiconducting substrate (11); and
a second tunneling layer (142) disposed between the second emitter (122) and the semiconducting substrate (11).

3. The solar cell according to claim 2, wherein the groove (13) penetrates through the first tunneling layer (141), dividing the first tunneling layer (141) into a first part (1411) located on the first region (11a) and a second part (1412) located on the second region (11b).

4. The solar cell according to claim 3, wherein the second region (11b) comprises a first sub-region (11b1) and a second sub-region (11b2) arranged adjacent to each other along the first direction (X), and the second sub-region (11b2) is located at a side of the first sub-region (11b1) adjacent to the first region (11a);
the second part (1412) covers the first surface of the semiconducting substrate (11) in second sub-region (11b2);
the second tunneling layer (142) covers the first surface of the semiconducting substrate (11) in the first sub-region (11b1) and a sidewall of the second sub-emitter (1212) that is away from the groove (13).

5. The solar cell according to claim 4, wherein the second tunneling layer (142) further covers a sidewall of the second part (1412) away from the groove (13) and a surface of the second sub-emitter (1212) away from the semiconducting substrate (11).

6. The solar cell according to claim 4, wherein the second emitter (122) covers a sidewall of the second part (1412) away from the groove (13) and a surface of the second sub-emitter (1212) away from the semiconducting substrate (11).

7. The solar cell according to claim 4, wherein 0<X1/X2≤1/10, where X1 is a size of the second part (1412) along the first direction (X), and X2 is a size of the second tunneling layer (142) on the first sub-region (11b1) along the first direction (X).

8. The solar cell according to claim 4, wherein the groove (13) extends to reach the semiconducting substrate (11).

9. The solar cell according to claim 8, wherein a distance between the second tunneling layer (142) located on the first sub-region (11b1) and the second surface is less than or equal to a distance between a bottom surface of the groove (13) formed by the first surface, and the second surface.

10. The solar cell according to any one of claims 1 to 9, further comprising a first dielectric layer (15) disposed on a side of the first emitter (121) away from the semiconducting substrate (11) and a side of the second emitter (122) away from the semiconducting substrate (11), wherein the first dielectric layer (15) covers the groove (13);
preferably, the solar cell further comprises a first passivation layer (16), wherein the first passivation layer (16) covers the groove (13);
preferably, the first passivation layer (16) further covers a surface of the first sub-emitter (1211) away from the semiconducting substrate (11) and a surface of the second emitter (122) away from the semiconducting substrate (11).

11. The solar cell according to any one of claims 1 to 10, wherein the semiconducting substrate (11) comprises a first diffusion region (111) and a second diffusion region (112), both extending from the first surface towards the second surface, an orthogonal projection of the first emitter (121) on the semiconducting substrate (11) covers at least a part of the first diffusion region (111), and an orthogonal projection of the second emitter (122) on the semiconducting substrate (11) covers at least a part of the second diffusion region (112);
preferably, the first diffusion region (111) comprises a first sub-diffusion region (1111) and a second sub-diffusion region (1112) spaced from each other in the first direction (X), an orthogonal projection of the first sub-emitter (1211) on the semiconducting substrate (11) coincides with the first sub-diffusion region (1111), and an orthogonal projection of the second sub-emitter (1212) on the semiconducting substrate (11) coincides with the second sub-diffusion region (1112).

12. The solar cell according to any one of claims 1 to 11, wherein a size of the first sub-emitter (1211) along the first direction (X) is greater than or equal to a size of the second emitter (122) along the first direction (X); and/or
an area of an orthogonal projection of the first sub-emitter (1211) on the semiconducting substrate (11) is greater than or equal to an area of an orthogonal projection of the second emitter (122) on the semiconducting substrate (11).

13. A method for preparing a solar cell, comprising:
providing a semiconducting substrate (11), the semiconducting substrate (11) comprising a first surface and a second surface opposite to each other, the semiconducting substrate (11) comprising a first region (11a) and a second region (11b) spaced from each other in a first direction (X), the first direction (X) being perpendicular to the thickness direction of the semiconducting substrate (11);
forming a first emitter (121) in a first conductivity type on the first surface; and
forming a second emitter (122) in a second conductivity type on the first surface in the second region (11b), a minimum distance between the second emitter (122) and the second surface being less than a minimum distance between the first emitter (121) and the second surface; and
forming a groove (13) in the first emitter (121), dividing the first emitter (121) into a first sub-emitter (1211) located on the first region (11a) and a second sub-emitter (1212) located on the second region (11b).

14. The method according to claim 13, wherein the second region (11b) comprises a first sub-region (11b1) and a second sub-region (11b2) arranged adjacent to each other along the first direction (X);
forming the first emitter (121) in the first conductivity type on the first surface comprises:
forming a first tunneling material layer, a first emitter material layer, and a first silicon oxide dielectric layer stacking on the first surface;
subjecting the semiconducting substrate (11) with the stacked layers to a first heat treatment;
and
removing the first silicon oxide dielectric material layer, the first emitter material layer, and the first tunneling material layer on the first sub-region (11b1);
preferably, forming the second emitter (122) in the second conductivity type on the first surface in the second region (11b) comprises:
forming a second tunneling material layer, a second emitter material layer, and a second silicon oxide dielectric layer stacking on the first surface;
subjecting the semiconducting substrate (11) with the stacked layers to a second heat treatment;
removing the second silicon oxide dielectric layer, the second emitter material layer, and the second tunneling material layer on the first region (11a) and a spacing region (11c),
wherein the spacing region (11c) is the region of the semiconducting substrate (11) between the first region (11a) and the second region (11b).

15. A photovoltaic module, comprising the solar cell according to any one of claims 1 to 12.
